# EUROPEAN PATENT APPLICATION

(11) **EP 4 742 512 A1**
(43) Date of publication of application: **13.05.2026**
(21) Application number: 25208232.6
(22) Date of filing: 13.10.2025
(51) Int. Cl.: H02K 7/14, H02K 9/06, H02K 11/33, B64D 27/34

(54) **A PROPULSION UNIT AND AIR MOBILITY APPARATUS**

(30) Priority: 08.11.2024 KR 20240157959
(71) Applicant: Hyundai Motor Company, Seoul 06797 (KR); Kia Corporation, Seoul 06797 (KR)
(72) Inventor: LEE, Sung Ho, Hwaseong-si, Gyeonggi-do (KR); SHIN, Kwon Su, Hwaseong-si, Gyeonggi-do (KR); AN, Jeong Uk, Hwaseong-si, Gyeonggi-do (KR); LIM, Ki Tack, Hwaseong-si, Gyeonggi-do (KR); JANG, Yong Sok, Hwaseong-si, Gyeonggi-do (KR); YEO, Kyung Ku, Hwaseong-si, Gyeonggi-do (KR); KIM, Chee Mann, Hwaseong-si, Gyeonggi-do (KR); LEE, Kyung Jun, Hwaseong-si, Gyeonggi-do (KR); LEE, Kam Chun, Hwaseong-si, Gyeonggi-do (KR); JUN, Hyun Woo, Hwaseong-si, Gyeonggi-do (KR); LEE, Jae Joon, Hwaseong-si, Gyeonggi-do (KR); YOO, Hoan Ju, Hwaseong-si, Gyeonggi-do (KR); LEE, Dong Su, Hwaseong-si, Gyeonggi-do (KR); HWANG, Yun Kyung, Hwaseong-si, Gyeonggi-do (KR); CHOI, Jong Hun, Hwaseong-si, Gyeonggi-do (KR); LEE, Hong Wook, Hwaseong-si, Gyeonggi-do (KR); JEUN, Jae Young, Hwaseong-si, Gyeonggi-do (KR)
(74) Representative: Isarpatent

(57) **Abstract**

A propulsion unit of an air mobility apparatus includes a stator, a rotor configured to rotate relative to the stator, and an inverter disposed radially inward relative to the stator in a radial direction of the stator and electrically connected to the stator. The propulsion unit further includes a propeller connected to the rotor and a cooling housing that is disposed adjacent to the stator and the inverter and that includes a cooling channel, the cooling housing being in contact with at least one component of the inverter.

## Description

### TECHNICAL FIELD

The present disclosure relates to an air mobility apparatus, and more particularly, to an air mobility apparatus including a propulsion unit.

### BACKGROUND

An air mobility apparatus is a transportation means capable of transporting people or cargo over a city and flying using a propulsion unit. In some cases, the propulsion unit of the air mobility apparatus may include a drive unit including a motor and an inverter that supplies electric power to the motor.

In some cases, the motor may include a stator and a rotor connected to a shaft, where the shaft is connected to the propeller. The rotor may rotate by electromagnetic interaction with the stator, and as the rotor rotates, the shaft and propeller may rotate.

In some cases, where the motor does not have a space therein, an inverter may be separately built and assembled to the motor. The inverter separately built from the motor, may increase a size of the propulsion unit.

In some cases, where the motor and the inverter are positioned apart from each other, a path connecting the motor and the inverter may become lengthy. In some cases, in order to cool the inverter, an additional cooling unit, in addition to a cooling unit of the motor, may be provided, which may lead to structural complexity of the propulsion unit and an increase of a size of the propulsion unit.

### SUMMARY

According to one aspect of the subject matter described in this application, a propulsion unit includes a stator, a rotor configured to rotate relative to the stator, and an inverter disposed radially inward relative to the stator in a radial direction of the stator and electrically connected to the stator.

Implementations according to this aspect can include one or more of the following features. For example, the propulsion unit can include a cooling housing that is disposed adjacent to the stator and the inverter and that includes a cooling channel, the cooling housing being in contact with at least one component of the inverter. In some examples, the stator can be disposed radially outward relative to the rotor.

In some implementations, the cooling housing can include a hub, a rim portion that is disposed at an outside of the hub in the radial direction and defines the cooling channel, and an arm that connects the hub to the rim portion. In some examples, one side of the at least one component of the inverter is in contact with the rim portion, and the inverter can further include a substrate that is in contact with another side of the at least one component of the inverter. In some examples, the at least one component can be fixed to an inner surface of the rim portion.

According to another aspect, an air mobility apparatus includes a propulsion unit, where the propulsion unit includes a propeller, a stator, a rotor connected to the propeller and configured to rotate relative to the stator, an inverter electrically connected to the stator, and a cooling housing that is disposed adjacent to the stator and the inverter and that includes a cooling channel, the cooling housing being in contact with at least one component of the inverter.

Implementations according to this aspect can include one or more of the following features. For example, the cooling housing can include a hub, a rim portion that is disposed at an outside of the hub and defines the cooling channel, and an arm that connects the hub to the rim portion. In some examples, one side of the at least one component of the inverter can be in contact with the rim portion, and the inverter can further include a substrate that is in contact with another side of the at least one component of the inverter. In some examples, the at least one component can be fixed to an inner surface of the rim portion.

In some implementations, the inverter is one of a first inverter and a second inverter that are provided at separate circuits and configured to operate independently. In some examples, the first inverter can be disposed at a first side of a reference line passing through a center of the rotor, and the second inverter can be disposed at a second side of the reference line opposite to the first side.

In some examples, the first inverter and the second inverter can be disposed symmetrically with respect to the reference line. In some examples, the stator and the inverter overlap with each other in a radial direction of the stator.

In some implementations, the cooling channel can be one of a plurality of cooling channels that are defined in the cooling housing and positioned between the stator and the inverter in the radial direction.

In some examples, the inverter can be positioned radially between an axial center of the propeller and the stator. In some examples, the stator can be disposed radially outward relative to the rotor.

### BRIEF DESCRIPTION OF THE DRAWINGS

The above and other objects, features and advantages of the present disclosure will become more apparent to those of ordinary skill in the art by describing example implementations thereof in detail with reference to the accompanying drawings.
FIG. 1 is a schematic diagram showing example modules in various types of movable air mobility apparatuses.
FIG. 2 is a view showing an example of an air mobility apparatus.
FIG. 3 is a side cross-sectional view showing an example of a propulsion unit of an air mobility apparatus.
FIG. 4 is a view showing an example of a cooling housing.
FIG. 5 is a view showing the cooling housing in which an inverter is disposed.
FIG. 6 is a block diagram showing an example of a first inverter and a second inverter.
FIG. 7 is a view showing an example of a component fixed to the cooling housing.
FIG. 8 is a side cross-sectional view showing example positions of the inverter and a motor.

### DETAILED DESCRIPTION

Hereinafter, one or more implementations will be described in detail with reference to the accompanying drawings, but the same or corresponding components are denoted by the same reference numerals regardless of the drawing numbers, and redundant descriptions thereof will be omitted.

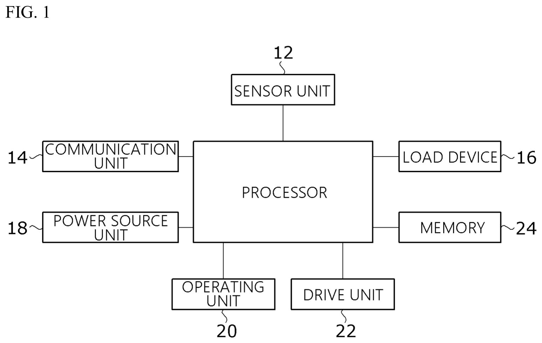

Hereinafter, FIG. 1 is a schematic diagram showing example modules in various types of movable air mobility apparatuses.

For example, an air mobility apparatus 10 can be a mobile body having mobility in the present disclosure. Mobility is the ability to carry people, objects for a specific purpose, and/or luggage while moving from one point to a specific point. That is, the air mobility apparatus 10 moves for transportation and other purposes, and the other purposes can include detecting or monitoring an environment around the air mobility apparatus 10 while carrying an observation device, for example. For a more specific example, the air mobility apparatus 10 can be equipped with a camera to photograph or analyze a surrounding environment and transmit the photographed or analyzed image to a predetermined device. The air mobility apparatus 10 can be used for various purposes without being limited to the above examples.

The air mobility apparatus 10 can move through spaces related to the ground, underground, air, space, sea, and/or underwater, depending on the space in which it moves. The ground or underground air mobility apparatus 10 can be provided in the form of, for example, a vehicle, a robot, or the like, and the air or space air mobility apparatus 10 can be provided as an aerial mobility apparatus, for example, in the form of a typical fixed-wing or rotary-wing aircraft, an advanced air mobility (AAM) that has been actively developed recently, an unmanned aircraft or drone, a rocket, a transportation means mounted on an artificial satellite, or the like. The sea or underwater air mobility apparatus 10 can be, for example, a ship, a submarine, or the like. The air mobility apparatus 10 can be a mobile body that can move through all of the spaces described above without being limited to a specific space, that is, a mobile body that can move between a plurality of spaces, for example, an amphibious vehicle, a flying vehicle, or the like.

In addition, the air mobility apparatus 10 can be moved through manual operation, autonomy control, or a combination thereof. The manual operation can be implemented by a driver or an operator through an interface such as a control device provided on the air mobility apparatus 10, or by remote control by a control center or an external control center. The autonomy control, that is, autonomous movement, can be performed by independent processing of the air mobility apparatus 10, or by a combination of remote control through a control center and collaborative processing of the air mobility apparatus 10 with the control center, or the like.

In some examples, the air mobility apparatus 10 can have various forms and can be differently designed depending on the purpose, movement space, driving method, control method, or the like. The air mobility apparatus 10 can have a common function module as exemplified in FIG. 1 from a comprehensive perspective such as mobility. FIG. 1 mainly describes common functions in various types of air mobility apparatuses 10. Accordingly, although a certain function module utilized in each type may omitted, the implementations of the present disclosure may not exclude a module that is omitted from the air mobility apparatus 10 in FIG. 1 and may not exclude the module from the scope of rights according to the present implementation.

The air mobility apparatus 10 can include a sensor unit 12, a communication unit 14, and a load device 16.

The sensor unit 12 can be equipped with various types of detectors that detect various states and situations occurring in external and internal environments of the air mobility apparatus 10 and identify the position information about the air mobility apparatus 10. That is, the sensor unit 12 can include different types of sensors and acquire sensing data detected from each sensor. The sensor unit 12 can obtain sensor data used for movement control, state data for detecting a state of modules constituting the air mobility apparatus 10, situation data for detecting the situation of occupants and/or loads, and the like, and provide them to a processor 26 that triggers a predetermined function and operation. In the present disclosure, the movement control can be at least one of motion controls related to linear movement, turning, and acceleration/deceleration of the air mobility apparatus 10, and attitude control, braking, hovering, and the like of the air mobility apparatus 10. In the present disclosure, hovering can be a control in which thrust is generated in a downward or vertical direction with respect to the air mobility apparatus 10, thereby causing a predetermined operation or movement of the air mobility apparatus 10. The predetermined operation or movement can be, for example, takeoff, landing, or substantially stationary flight within a limited range. The data of the sensor unit 12 described above is merely exemplary, and can additionally include sensor data for detecting various situations not listed herein.

The communication unit 14 can support mutual communication with other devices to exchange data with other external devices. Examples of other devices can include a server that controls the air mobility apparatus 10 or mutually exchanges data related to movement control of the air mobility apparatus 10, ancillary devices for supporting movement, other mobility apparatuses, or the like. The server can be referred to by various terms, such as a control device, a management device, a controlling device, or the like. The communication unit 14 can transmit data generated or stored during movement to another device and receive data and software modules transmitted from another device. A protocol applied to the communication unit 14 can be determined according to the type of air mobility apparatus 10, and can allow communication with other vehicles or other devices, for example, based on cellular communication, wireless access in vehicular environment (WAVE) communication, dedicated short range communication (DSRC), or short-range communication, or other communication methods. The communication protocol and methods listed above are exemplary and not limiting.

The load device 16 can be an auxiliary device that is mounted on the air mobility apparatus 10 and consumes electric power supplied from a power source unit 18 or converted from the output of the power source unit 18 by a command for use by a user or management of loads. The load device 16 can be a type of non-mobile electric device other than a mobile power system used in the drive unit 22 or the like in the present disclosure. The load device 16 can be, for example, a display system, an air conditioning system, a lighting system, a seat system, and various devices installed in the air mobility apparatus 10.

In some implementations, the air mobility apparatus 10 can include an interface for receiving requests for movement control and the operation of the load device 16. The interface can be implemented as a hardware device, a software interface, or the like. The hardware interface can be a hardware manipulator for the movement motion that the user requests from the air mobility apparatus 10, and can be, for example, an aircraft joystick, a ground steering wheel, a ground pedal, a button, a marine steering handler, or the like, but is not limited thereto. The software interface can be a touch-enabled display, for example, but is not limited thereto.

In addition, the air mobility apparatus 10 can include a power source unit 18, an operating unit 20, and a drive unit 22.

The power source unit 18 can generate and supply power and electric power used in the mobile power system such as the drive unit 22 and the load device 16. The air mobility apparatus 10 can generate energy by at least one of various energy sources. When the air mobility apparatus 10 is driven by electric energy, the power source unit 18 can be, for example, an electric battery, or a combination of an electric battery and a charging module that charges the battery. When the power source unit 18 is an electric battery only, the electric battery can be charged from a charging station or other mobility apparatus to supply electric power. In the case of the combination of the electric battery and the charging module, the power source unit 18 can employ at least one of a fuel cell and a fossil energy-based engine as the charging module. The fuel cell can use substances, such as hydrogen gas, to generate electric power. In the case of the engine, the power source unit 18 can have a generator coupled to the engine, and the generator can convert mechanical energy generated by the engine into electrical energy and charge the electric battery with the converted electrical energy.

As another example, when the air mobility apparatus 10 is driven by fossil energy or nuclear fuel, the power source unit 18 can be an internal combustion engine, a turbine engine, or a nuclear fuel-based engine. As still another example, the air mobility apparatus 10 can have the power source unit 18 configured in a hybrid form by a fossil energy-based engine and an electric battery. The hybrid power source unit 18 can charge the electric battery using the engine output generated during movement, and can generate a driving force for the drive unit 22 by selecting any one of the power of the engine or the electric power of the electric battery depending on the state of the air mobility apparatus 10, the properties of a movement route, a movement situation, and the like. As another example, the hybrid power source unit 18 can include an electric battery that can be charged by an external source and an engine. The processor 26 switches between the power of the engine and the electric power of the electric battery depending on various situations and states to apply the energy to the drive unit 22, and thus, a moving driving force can be generated.

The operating unit 20 and the drive unit 22 can form an actuating unit that transmits power generated from the power source unit 18 to implement a predetermined movement motion to the outside. In the present disclosure, the actuating unit is referred to as an actuator, and the terms can be interchangeably used and described.

The operating unit 20 can be equipped with at least one module that implements a movement motion. When the air mobility apparatus 10 is an air mobility apparatus, the operating unit 20 can be equipped with mechanical and software components that perform at least one operation among, for example, control of flight attitudes such as roll, yaw, pitch, and the like, of the air mobility apparatus 10, hovering control related to takeoff and landing, and flap control for altitude change and turning operation. When the air mobility apparatus 10 is a ground mobility, the operating unit 20 can have mechanical and software components that realize at least one driving operation, for example, longitudinal control such as acceleration and deceleration, and lateral control such as steering. The operating unit 20 of the ground mobility can further include a module for transmitting power from the power source unit 18 to the drive unit 22 and a module for converting the power to the drive unit 22 into power with a predetermined size and shape.

The drive unit 22 can be a module for externally implementing linear movement, turning, acceleration/deceleration of the air mobility apparatus 10, and attitude control, braking, hovering, or the like, of the air mobility apparatus 10, and can be implemented in various forms depending on the type of the air mobility apparatus 10. When the air mobility apparatus 10 is a typical air mobility apparatus, a moving drive unit of a fixed-wing mobility apparatus can be a turbine engine, a flap, or the like, installed on a main wing, a tail wing, or the like, to realize motions related to the thrust and lift of the air mobility apparatus. As another example, the fixed-wing air mobility apparatus can additionally include a propulsion unit, such as a propeller, on a designated portion of the main wing. The drive unit 22 of a typical rotary wing air mobility apparatus can be a rotor type propulsion unit, a flap, or the like, installed on an upper portion of a fuselage and the tail wing. The typical air mobility apparatus can be equipped with wheels, such as landing gear for takeoff and landing, depending on its specifications, and wheels can be accommodated within the fuselage during flight. The AAM type drive unit 22 can be equipped with a rotor type propulsion unit and a flap, similar to a rotary wing air mobility apparatus. The propulsion unit applied to the AAM type drive unit can be fixed to the main wing to be at least non-tiltable, or can be installed in the main wing to be at least tiltable. As another example, a plurality of propulsion units that are applied to the AAM type drive unit can also be installed inside the main wing. In addition, the AAM type drive unit 22 can be configured to rotate the wing to which the propulsion unit is coupled within a predetermined angular range. The AAM type drive unit 22 can be equipped with wheels, such as landing gear, which are accommodated within the fuselage during flight and taken out during takeoff and landing, depending on the specifications. When the AAM type air mobility apparatus is driven by electric energy, the drive unit 22 can mainly include a motor that rotates the propeller by electric power and an inverter. When the AAM type air mobility apparatus is driven by non-electric energy, such as fossil energy, the drive unit 22 can mainly include modules for transmitting rotational power generated by an internal combustion engine to the propeller.

When the air mobility apparatus 10 is a ground mobility, the drive unit 22 can include a plurality of wheels, a driving force transmission module for generating a driving force and applying the driving force to the wheels or transmitting the driving force, a braking module for slowing down the driving of the wheels, a steering module for realizing lateral control of the wheels, and the like. Wheels, the driving force transmission module, the braking module, and the like, can constitute a driving assembly, and a plurality of driving assemblies can be provided depending on the number of wheels.

When the air mobility apparatus 10 is driven based on electrical energy, the driving force transmission module can be configured as a motor module that generates a driving force based on electric power output from the electric battery.

In addition, the air mobility apparatus 10 can include a memory 24 and a processor 26.

The memory 24 can store applications and various data for controlling the air mobility apparatus 10 and load applications or read and record data by a request of the processor 26. The applications and data can vary depending on the type and detailed specifications of the air mobility apparatus 10, and include sensor data related to movement control, state data of the mobility apparatus related to movement control, data received from other devices, and data related to energy control between the power source unit 18 and the drive unit 22. In addition, the applications and data can include data related to the control of modules in charge of functions other than the controls described above, software related to the operation of the computing system of the mobility apparatus, information and applications for autonomous movement, route information, various information and control programs for boarding convenience, or the like.

Regarding the present disclosure, the processor 26 can process movement control, route control, energy control, control of the load device 16, autonomous movement control, convenience function control, or the like, using the applications, instructions, and data stored in the memory 24. The processor 26 can also have different control processes depending on the type and detailed specifications of the air mobility apparatus 10. The processor 26 may, for example, be implemented as a single processing module. As another example, the processing according to the above-described matters can be distributed in a plurality of processing modules, and the plurality of processing modules can be collectively referred as the processor 26 in the present disclosure.

In the present disclosure, among various types of air mobility apparatuses, the AAM type air mobility apparatus is mainly described. Although the AAM type air mobility apparatus is described, functions, modules, and devices of the air mobility apparatus described in the present disclosure are also applicable to other types of air mobility apparatuses as long as the functions, modules, and devices are technically combinable. In a broad sense, when the functions, modules, and devices of the air mobility apparatus described in the present disclosure are technically combinable, the functions, modules, and devices can also be applicable to mobility apparatuses on land, underground, space, sea, and underwater.

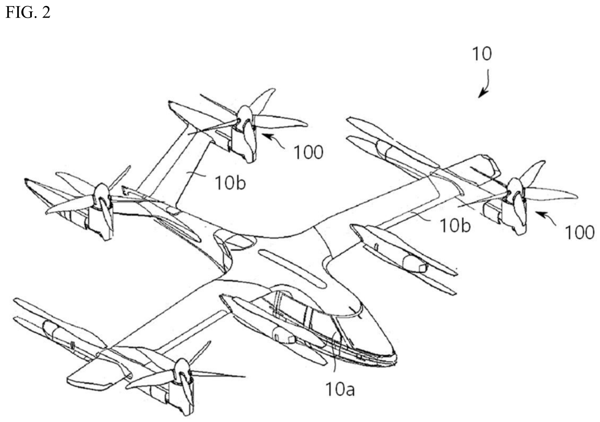

FIG. 2 is a view showing an example of an air mobility apparatus.

In some implementations, the air mobility apparatus 10 can include a streamlined fuselage 10a and wings 10b such as a main wing and a tail wing connected to the fuselage 10a. The fuselage 10a can have, for example, a cabin for the pilot and passengers and a space for loading baggage.

In some examples, a plurality of propulsion units can be disposed on the wings 10b, and each of the propulsion units 100 can include a propeller and a motor that rotates the propeller, an inverter that adjusts the electric power of the power source unit 18 or converts an electric power form based on a flight situation, motor specifications, or the like, and a cooling unit that cools heat generated in the motor and the inverter. The propeller can be arranged parallel to the fuselage 10a.

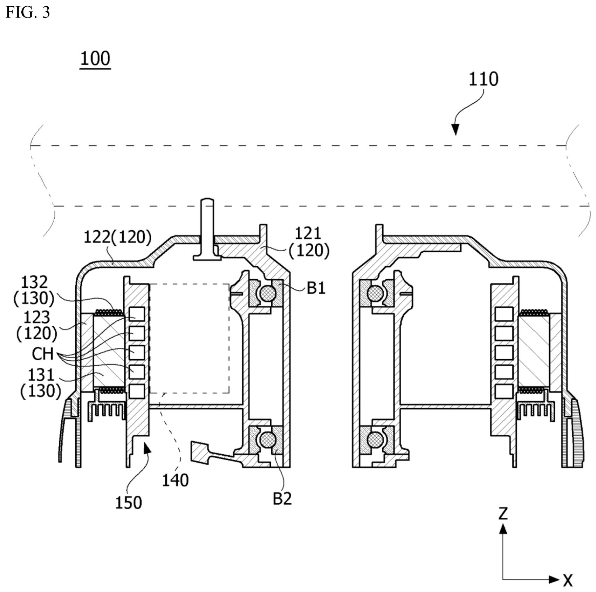

FIG. 3 is a side cross-sectional view showing an example of a propulsion unit 100 of an air mobility apparatus.

Referring to FIG. 3, the propulsion unit 100 of the mobility apparatus can include a propeller 110, a rotor 120, a stator 130, an inverter 140, and a cooling housing 150.
Hereinafter, an axial direction of the propulsion unit 100 represents a longitudinal direction of a shaft 121, and a radial direction represents a direction perpendicular to the axial direction. Hereinafter, in the drawings, a z-axis represents the axial direction, and an x-axis represents the radial direction.

The propeller 110 is coupled to the shaft 121 of the rotor 120 to generate lift by rotating together when the rotor 120 rotates.

The rotor 120 can include the shaft 121, a yoke 122, and a magnet 123. The yoke 122 can be a cylindrical member with one end open in the axial direction. The shaft 121 can be coupled to an upper portion of the yoke 122. Further, the magnet 123 can be fixed to an inner surface of a side portion of the yoke 122. The magnet 123 can be formed by combining a plurality of split magnets, or can be a single ring-shaped magnet.

The stator 130 can be fixed to the cooling housing 150. The stator 130 is positioned opposite the rotor 120. The stator 130 can be positioned on an inner side of the stator 130 in the radial direction. That is, the rotor 120 can be disposed on an outer side of the stator 130.
Here, the term "inner" refers to a direction toward the shaft 121 based on the radial direction, and the term "outer" refers to a direction away from the shaft 121 based on the radial direction.

The stator 130 can include a coil 132 wound around a stator core 131.

The inverter 140 can be fixed to the cooling housing 150. Further, the inverter 140 can be positioned on an inner side of the stator 130. That is, the inverter 140 can be disposed to overlap the stator 130 in the radial direction. The inverter 140 can be disposed closer to an axial center of the propeller 110 in the radial direction than the stator 130. Since the inverter 140 is disposed between the stator 130 and the shaft 121 in the radial direction in this way, there is an advantage in that the size of the propulsion unit 100 can be significantly reduced in the axial direction.

The cooling housing 150 is disposed on an outer side of the shaft 121. Further, the cooling housing 150 is positioned on the inner side of the stator 130. The cooling housing 150 can include a plurality of cooling channels CH. The cooling channels CH can be positioned between the stator 130 and the inverter 140 in the radial direction. Unlike the shaft 121, the cooling housing 150 does not rotate but is fixed. Bearings B1 and B2 can be fixed to the cooling housing 150. The bearings B1 and B2 rotatably support the shaft 121. The bearings B1 and B2 can include an upper bearing B1 and a lower bearing B2. The upper bearing B1 can be disposed at an upper portion of the cooling housing 150, and the lower bearing B2 can be disposed at a lower portion of the cooling housing 150.

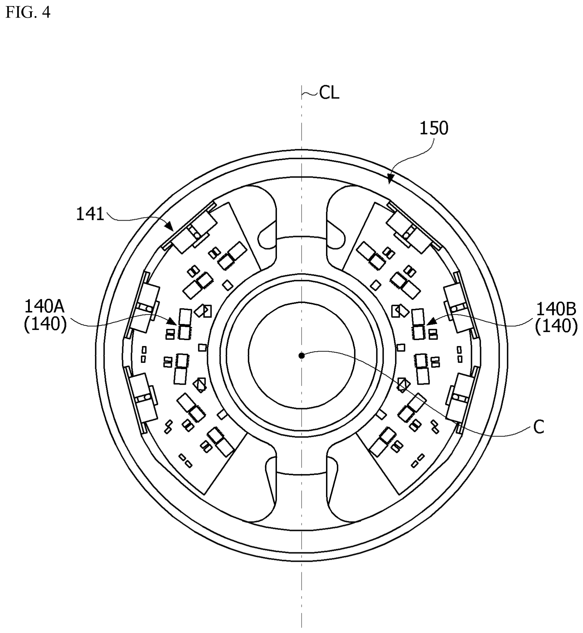

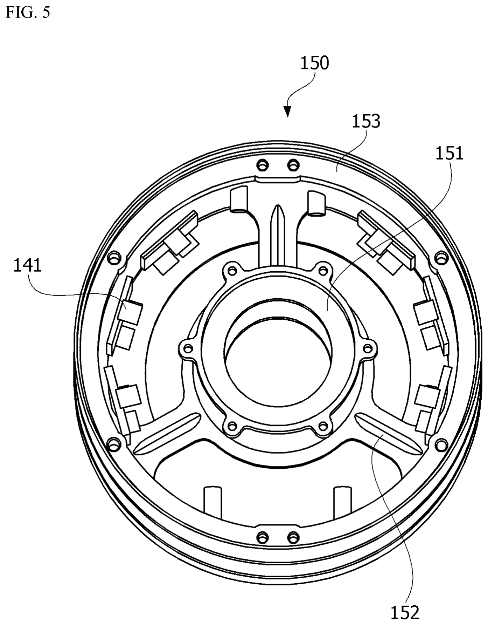

FIG. 4 is a view showing the cooling housing 150, and FIG. 5 is a view showing the cooling housing 150 in which the inverter 140 is disposed.

Referring to FIGS. 4 and 5, the cooling housing 150 can include a cylindrical hub 151, a female portion 152 extending from the hub 151 in the radial direction, and a rim portion 153 connected to the female portion 152. A cooling channel CH can be formed inside the rim portion 153. For example, the cooling channel CH can be an empty space of the cooling housing 150 formed along the rim portion 153, and through the space, coolant flows. In some examples, a plurality of cooling channels CH can be provided in the cooling housing 150.

The stator 130 is fixed by being in contact with the outer surface of the rim portion 153. The inverter 140 can be positioned on the inner side of the rim portion 153. Among the components of the inverter 140, a component 141 that generates a lot of heat can be fixed to the rim portion 153 by being in direct contact with the inner surface of the rim portion 153.

As shown in FIG. 5, the inverter 140 can be positioned between the rim portion 153 and the hub 151 in the radial direction and fixed to the cooling housing 150. Since the inverter 140 is disposed directly adjacent to the rim portion 153 having the cooling channel CH, the heat generated in the inverter 140 can be directly and effectively exchanged with the coolant flowing in the cooling channel CH. The component 141 in direct contact with the cooling housing 150 can be a silicon carbide power module.

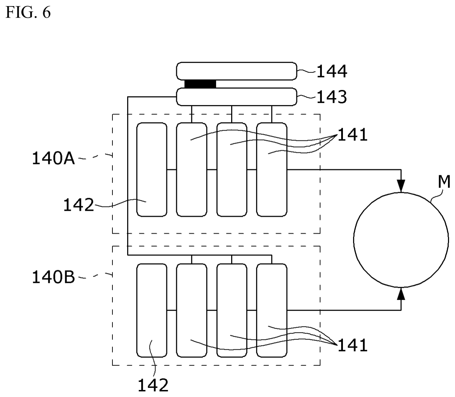

FIG. 6 is a block diagram showing an example of a first inverter 140A and a second inverter 140B.

Referring to FIGS. 4 and 6, the inverter 140 can include the first inverter 140A and the second inverter 140B.

The first inverter 140A and the second inverter 140B are provided on separate circuits to operate independently. When any one of the first inverter 140A and the second inverter 140B fails, electric power can be supplied to a motor M through the inverter 140 that is not failed.

The first inverter 140A can include a control board 144, a gate board 143 electrically connected to the control board 144, and a capacitor board 142 electrically connected to the control board 144 and the gate board 143. The gate board 143 can be connected to a component 141 of the first inverter 140A. For example, the component 141 can be a silicon carbide (SiC) power module.

The second inverter 140B can also include a control board 144, a gate board 143 electrically connected to the control board 144, and a capacitor board 142 electrically connected to the control board 144 and the gate board 143. The gate board 143 can be connected to a component 141 of the second inverter 140B. The component 141 can be a silicon carbide (SiC) power module.

When viewed in the axial direction, the first inverter 140A can be disposed on one side of a reference line CL passing through the center of the axis, and the second inverter 140B can be disposed on the other side of the reference line CL. The first inverter 140A and the second inverter 140B can be disposed symmetrically with respect to the reference line CL.

The component 141 of the first inverter 140A can be disposed on one side of the reference line CL, and the component 141 of the second inverter 140B can be disposed on the other side of the reference line CL. A plurality of components 141 can be disposed. Each of the plurality of components 141 can be fixed to an inner surface of the cooling housing 150. For example, three components 141 of the first inverter 140A are provided, and the three components 141 can be disposed at a set interval on an inner surface of the cooling housing 150 along a circumferential direction of the cooling housing 150. Three components 141 of the second inverter 140B are also provided, and the three components 141 can be disposed at a set interval on an inner surface of the cooling housing 150 along a circumferential direction of the cooling housing 150.

The components 141 of the first inverter 140A and the components 141 of the second inverter 140B can be disposed symmetrically with respect to the reference line CL.

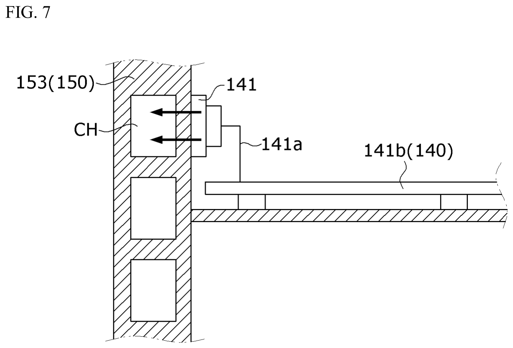

FIG. 7 is a drawing showing a component 141 fixed to the cooling housing 150.

Referring to FIG. 7, the component 141 can be fixed in a state of being in contact with an inner surface of the rim portion 153 of the cooling housing 150. In the axial direction, the component 141 can be positioned spaced apart from a substrate 141b of the inverter 140. The component 141 and the substrate 141b can be connected through a separate connection terminal 141a. In the radial direction, the component 141 can be disposed to overlap the cooling channel CH.

The heat generated in the component 141 can be transferred to the cooling housing 150 and removed through heat exchange with the coolant flowing through the cooling channel CH. In this way, since the component 141 is in direct contact with the cooling housing 150 and is positioned to be as close as possible to the cooling channel CH, the heat generated in the component 141 can be effectively removed.

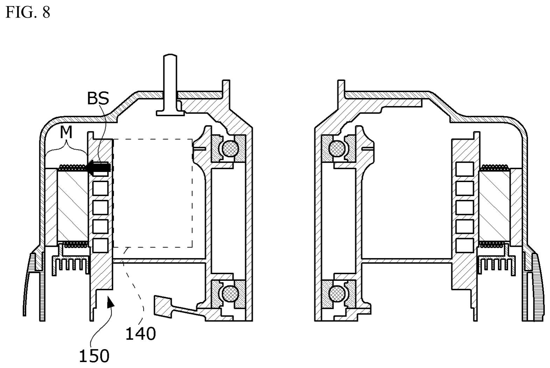

FIG. 8 is a side cross-sectional view showing the positions of the inverter 140 and the motor M.

Referring to FIG. 8, the inverter 140 is disposed adjacent to the motor M with the cooling housing 150 interposed therebetween in the radial direction. Since the inverter 140 is positioned inward of the motor M in the radial direction, the size of the propulsion unit 100 can be significantly reduced in the axial direction. In addition, by disposing the cooling housing 150 between the inverter 140 and the motor M in the radial direction so that the motor M and the inverter 140 share the cooling housing 150, since there is no need to provide a separate cooling unit to cool the inverter 140, the configuration can be simplified and the size of the propulsion unit 100 can be reduced.

In some examples, since the motor M is positioned directly adjacent to the inverter 140 with the cooling housing (150) interposed therebetween in the radial direction, there is an advantage in that a path of a bus bar (BS) connecting the motor M and the inverter 140 is shortened. This helps to simplify the configuration of the bus bar BS and reduce the size and weight of the propulsion unit 100.

In some implementations, an inverter is disposed between a shaft and a stator, so that there is an advantage of reducing the size of a propulsion unit.

In some implementations, since an inverter is disposed radially adjacent to a stator, there is an advantage of significantly reducing a connection path between a motor and the inverter.

In some implementations, a high-heat generating component of an inverter comes into direct contact with a cooling housing, so that there is an advantage of increasing the cooling efficiency of the inverter.

In some implementations, since cooling channels are positioned between a stator and an inverter based on a radial direction perpendicular to an axial direction, there is an advantage in that a distance between the stator and the inverter can be reduced and the overall size and weight of the propulsion unit can be reduced.

Although example implementations of the present disclosure have been described above, it is understood that those skilled in the art can make various changes and modifications to the present disclosure without departing from the spirit and scope of the present disclosure set forth in the claims below.

## Claims

1. A propulsion unit comprising:
a stator;
a rotor configured to rotate relative to the stator; and
an inverter disposed radially inward relative to the stator in a radial direction of the stator and electrically connected to the stator.

2. The propulsion unit of claim 1, wherein the stator is disposed radially outward relative to the rotor.

3. The propulsion unit of claim 1, further comprising:
a cooling housing that is disposed adjacent to the stator and the inverter and that includes a cooling channel, the cooling housing being in contact with at least one component of the inverter.

4. The propulsion unit of claim 3, wherein the cooling housing comprises:
a hub;
a rim portion that is disposed at an outside of the hub in the radial direction and defines the cooling channel; and
an arm that connects the hub to the rim portion.

5. The propulsion unit of claim 4, wherein one side of the at least one component of the inverter is in contact with the rim portion, and
wherein the inverter further comprises a substrate that is in contact with another side of the at least one component of the inverter.

6. The propulsion unit of claim 5, wherein the at least one component is fixed to an inner surface of the rim portion.

7. An air mobility apparatus comprising a propulsion unit, wherein the propulsion unit comprises:
a propeller;
a stator;
a rotor connected to the propeller and configured to rotate relative to the stator;
an inverter electrically connected to the stator; and
a cooling housing that is disposed adjacent to the stator and the inverter and that includes a cooling channel, the cooling housing being in contact with at least one component of the inverter.

8. The air mobility apparatus of claim 7, wherein the cooling housing comprises:
a hub;
a rim portion that is disposed at an outside of the hub and defines the cooling channel; and
an arm that connects the hub to the rim portion.

9. The air mobility apparatus of claim 8, wherein one side of the at least one component of the inverter is in contact with the rim portion, and
wherein the inverter further comprises a substrate that is in contact with another side of the at least one component of the inverter.

10. The air mobility apparatus of claim 9, wherein the at least one component is fixed to an inner surface of the rim portion.

11. The air mobility apparatus of claim 7, wherein the inverter is one of a first inverter and a second inverter that are are provided at separate circuits and configured to operate independently.

12. The air mobility apparatus of claim 11, wherein the first inverter is disposed at a first side of a reference line passing through a center of the rotor, and
wherein the second inverter is disposed at a second side of the reference line opposite to the first side.

13. The air mobility apparatus of claim 12, wherein the first inverter and the second inverter are disposed symmetrically with respect to the reference line.

14. The air mobility apparatus of claim 7, wherein the stator and the inverter overlap with each other in a radial direction of the stator.

15. The air mobility apparatus of claim 14, wherein the cooling channel is one of a plurality of cooling channels that are defined in the cooling housing and positioned between the stator and the inverter in the radial direction.

16. The air mobility apparatus of claim 15, wherein the inverter is positioned radially between an axial center of the propeller and the stator.

17. The air mobility apparatus of claim 7, wherein the inverter is disposed radially inward relative to the stator in a radial direction of the stator, and
wherein the stator is disposed radially outward relative to the rotor in the radial direction.
